# EUROPÄISCHE PATENTANMELDUNG

(11) **EP 3 498 883 A1**
(43) Veröffentlichungstag der Anmeldung: **19.06.2019**
(21) Anmeldenummer: 17207102.9
(22) Anmeldetag: 13.12.2017
(51) Int. Cl.: C23C 14/20, B05D 5/06, B05D 7/00, C23C 14/00

(54) **VERFAHREN ZUR HERSTELLUNG BESCHICHTETER SUBSTRATE, BESCHICHTETE SUBSTRATE UND DEREN VERWENDUNG**

(71) Anmelder: HEC High End Coating GmbH, 35108 Allendorf (Eder) (DE)
(72) Erfinder: KOCH, Matthias, 59969 Bromskirchen (DE)
(74) Vertreter: Metten, Karl-Heinz

(57) **Zusammenfassung**

Die vorliegende Erfindung betrifft ein Verfahren zur Herstellung eines beschichteten metallischen oder nicht-metallischen Substrats, das insbesondere nach dem erfindungsgemäßen Verfahren erhältliche beschichtete Substrat sowie die Verwendung der erfindungsgemäßen beschichteten Substrate.

## Beschreibung

Die vorliegende Erfindung betrifft ein Verfahren zur Herstellung beschichteter Substrate, beschichtete Substrate und die Verwendung dieser beschichteten Substrate.

Metallische wie nicht-metallische Bauteile werden häufig zur Erzeugung einer glatten und/oder glänzenden Oberfläche beschichtet. In der Regel handelt es sich hierbei um mehrlagige Beschichtungssysteme. Neben dem Wunsch, eine Oberfläche mit hochwertiger Anmutung zu erhalten, wird mit derartigen Beschichtungssystemen regelmäßig auch ein ausgeprägter Korrosionsschutz angestrebt. Ein dauerhafter Korrosionsschutz wird nicht selten durch mechanische Beschädigung zunichte gemacht. Vielfach setzt bereits bei geringfügigen mechanischen Beschädigungen beschichteter Oberflächen Korrosion ein. Dies kann neben Verfärbungen auch Unterwanderungsphänomene zur Folge haben. Nicht selten führt dies dann zum Abplatzen von Beschichtungsarealen. Es hat nicht an Versuchen gefehlt, beschichtete glänzende Oberflächen korrosionsbeständig auszustatten. Beispielsweise beschreibt die DE 123 765 A1 ein Verfahren zur Erzeugung einer Korrosionsschutzschicht auf einer metallischen Oberfläche, bei dem ein auf Siliziumverbindungen basierendes Sol, ein Aminoalkyl-funktionalisiertes Alkoxysilan oder ein Umsetzungsprodukt der beiden vorangehend genannten Komponenten zum Einsatz kommt.

Gemäß der DE 38 33 119 C2 erhält man eine sehr gut auf einem Substrat haftende korrosionsgeschützte chromatierte Metalloberfläche dadurch, dass ein Elektrotauchlack direkt auf die Chromatierschicht ohne Zwischentrocknung abgeschieden wird.

Vielfach versucht man das Problem des Korrosionsschutzes bzw. der Erzeugung von glatten beschichteten Oberflächen dadurch zu lösen, dass man für einzelne Schichten oder sogleich für mehrere Schichten eines Beschichtungssystems den Materialauftrag, d.h. die Schichtdicke erhöht. Hierdurch steigen nicht nur die eingesetzte Menge, der Arbeitsaufwand und die Kosten, auch kommt es häufig zu einem ungewünschten Materialauftrag im Rand- bzw. Kantenbereich von Bauteilen.

Korrosionsschutzbeschichtungen insbesondere für Metallsubstrate zeigen noch stets erhebliches Verbesserungspotential in Sachen Optik, Haftung und Korrosionsschutz, insbesondere bei massengefertigten Produkten, vor allem solchen mit anspruchsvoller Geometrie.

Auch ist es vielfach nicht trivial, hochwertig anmutende Substratoberflächen auf einfache und kostengünstige Weise in der Massenfertigung reproduzierbar herzustellen. Derartige Oberflächen bedürfen zumeist des Einsatzes der Galvanotechnik. Um sogenannte schwarz verchromte Beschichtungen zu erhalten, welche häufig eine besonders edle Anmutung liefern, ist der Aufwand noch einmal zu erhöhen. Denn hierfür benötigt man eine erhöhte Stromdichte in Verbindung mit speziellen Zusätzen.

Der vorliegenden Erfindung lag daher die Aufgabe zu Grunde, beschichtete Substrate zur Verfügung zu stellen, die nicht mehr mit den Nachteilen des Stands der Technik behaftetet sind und die insbesondere auch in der Massenfertigung beschichtete Produkte mit verbessertem Korrosionsschutz und/oder sehr guten Haftungseigenschaften und/oder hochwertigen Oberflächeneigenschaften liefern. Es werden dabei auch solche beschichteten Produkte angestrebt, die bei mechanischer Oberflächenbeschädigung nicht sogleich Unterwanderungsphänomene zeigen, insbesondere auch nicht verbunden mit dem Abblättern von Schichten. Des Weiteren lag der Erfindung die Aufgabe zugrunde, zu beschichteten Substraten zu gelangen, die selbst mit komplexer Geometrie über das gesamte Bauteil, einschließlich im Bereich von Kantenverläufen, ein gleichwertig hohes Beschichtungsergebnis zeigen.

Demgemäß wurde ein Verfahren zur Herstellung eines beschichteten metallischen Substrats oder eines beschichteten nicht-metallischen Substrats, insbesondere Kunststoffsubstrats, umfassend
a) Zurverfügungstellung eines metallischen Substrats oder eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage, und Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
c) gegebenenfalls Reinigen der mindestens einen zumindest bereichsweise beschichtbaren Oberfläche,
d) gegebenenfalls Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit einem Vakuum (d1)) und/oder Plasmabehandlung mit dem Plasmagenerator und/oder Corona-Behandlung, insbesondere Plasmabehandlung, des metallischen Substrats oder des nicht-metallischen Substrats, insbesondere Kunststoffsubstrats, oder der beschichtbaren Oberfläche des nicht-metallischen Substrats, insbesondere Kunststoffsubstrats, oder des metallischen Substrats, insbesondere im Vakuum (d2)),
e) gegebenenfalls Behandeln des nach Schritt a), c) oder d), insbesondere d1) und d2), erhaltenen metallischen Substrats oder nicht-metallischen Substrats, insbesondere Kunststoffsubstrats, oder der nach Schritt a), c) oder d), insbesondere d1) und d2), erhaltenen beschichtbaren Oberfläche des metallischen Substrats oder des nicht-metallischen Substrats, insbesondere Kunststoffsubstrats, mit mindestens einer siliziumorganischen Verbindung, insbesondere mittels Plasmapolymerisation, insbesondere unter Ausbildung einer Polysiloxanschicht,
f) gegebenenfalls Plasmabehandlung mit dem Plasmagenerator und/oder Corona-Behandlung, insbesondere Plasmabehandlung, der Schicht, insbesondere Polysiloxanschicht, gemäß Schritt e),
g) gegebenenfalls Aufbringen mindestens einer Grundierungsschicht auf das metallische Substrat oder das nicht-metallische Substrat, insbesondere Kunststoffsubstrat, oder die beschichtbare Oberfläche des metallischen Substrats oder des nicht-metallischen Substrats, insbesondere Kunststoffsubstrats, gemäß Schritt a), c) oder d), insbesondere d1) und d2), oder auf die Schicht, insbesondere Polysiloxanschicht, gemäß Schritt e) oder f),
h) gegebenenfalls Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, gemäß Schritt g) mit einem Vakuum (h1)) und/oder Plasmabehandlung mit dem Plasmagenerator und/oder Corona-Behandlung, insbesondere Plasmabehandlung, des metallischen Substrats oder des nicht-metallischen Substrats, insbesondere Kunststoffsubstrats, oder der beschichtbaren Oberfläche des nicht-metallischen Substrats, insbesondere Kunststoffsubstrats, oder des metallischen Substrats gemäß Schritt h1) oder Schritt g), vorzugsweise im Vakuum (h2)),
i) gegebenenfalls Behandeln der nach Schritt g) oder h), insbesondere h1) und h2), erhaltenen Grundierungsschicht mit mindestens einer siliziumorganischen Verbindung, insbesondere mittels Plasmapolymerisation, insbesondere unter Ausbildung einer Polysiloxanschicht,
j) gegebenenfalls Plasmabehandlung mit dem Plasmagenerator und/oder Corona-Behandlung, insbesondere Plasmabehandlung, der Schicht, insbesondere Polysiloxanschicht, gemäß Schritt i),
k) Aufbringen mindestens einer ersten Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das nicht-metallische Substrat, insbesondere Kunststoffsubstrat, oder auf die beschichtbare Oberfläche des nicht-metallischen Substrats, insbesondere Kunststoffsubstrats, gemäß Schritt a), c) oder d), insbesondere d1) und d2), oder auf die Schicht, insbesondere Polysiloxanschicht, gemäß Schritt e) oder f) oder auf die Grundierungsschicht gemäß Schritt g) oder h), insbesondere h1) und h2), oder auf die Schicht, insbesondere Polysiloxanschicht, gemäß Schritt i) oder j),
l) gegebenenfalls Plasmabehandlung mit dem Plasmagenerator und/oder Corona-Behandlung, insbesondere Plasmabehandlung, der ersten Metallschicht gemäß Schritt k),
m) vorzugsweise Behandeln der nach Schritt k) oder l) erhaltenen ersten Metallschicht mit mindestens einer siliziumorganischen Verbindung, insbesondere mittels Plasmapolymerisation, insbesondere unter Ausbildung einer Polysiloxanschicht,
n) vorzugsweise Plasmabehandlung mit dem Plasmagenerator und/oder Corona-Behandlung, insbesondere Plasmabehandlung, der Schicht, insbesondere Polysiloxanschicht, gemäß Schritt m),
o) Aufbringen mindestens einer, gegebenenfalls eingefärbten, Grundierungsschicht auf die Schicht, insbesondere Polysiloxanschicht, gemäß Schritt n),
p) Beaufschlagen der Grundierungsschicht gemäß Schritt o) mit einem Vakuum (p1)) und/oder Plasmabehandlung der Grundierungsschicht, vorzugsweise im Vakuum, mit dem Plasmagenerator im Vakuum und/oder Corona-Behandlung, insbesondere Plasmabehandlung (p2)),
q) Aufbringen mindestens einer zweiten Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, insbesondere unmittelbar auf die plasma- und/oder coronabehandelte, insbesondere plasmabehandelte, Grundierungsschicht gemäß Schritt p), insbesondere p1) und p2),
r) gegebenenfalls Plasmabehandlung, vorzugsweise im Vakuum, mit dem Plasmagenerator und/oder Corona-Behandlung, insbesondere Plasmabehandlung, der zweiten Metallschicht gemäß Schritt q),
s) vorzugsweise Behandeln der nach Schritt q) oder r) erhaltenen zweiten Metallschicht mit mindestens einer siliziumorganischen Verbindung, insbesondere mittels Plasmapolymerisation, insbesondere unter Ausbildung einer Polysiloxanschicht,
t) vorzugsweise Plasmabehandlung, vorzugsweise im Vakuum, mit dem Plasmagenerator und/oder Corona-Behandlung, insbesondere Plasmabehandlung, der Schicht, insbesondere Polysiloxanschicht, gemäß Schritt s), und
u) Auftragen mindestens einer, insbesondere transparenten und/oder eingefärbten, Deckschicht auf die behandelte Schicht, insbesondere Polysiloxanschicht, gemäß Schritt t).

In einer bevorzugten Ausführungsvariante umfasst das erfindungsgemäße Verfahren die Schritte
a) Zurverfügungstellung eines metallischen Substrats oder eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage, und Zurverfügungstellung mindestens eines Plasmagenerators, insbesondere in der Applikationsanlage für die Aufbringung einer Metallschicht, wie Vakuumaufdampfanlage oder Sputter-Anlage, oder als Bestandteil hiervon,
c) gegebenenfalls Reinigen der mindestens einen zumindest bereichsweise beschichtbaren Oberfläche,
d) Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit einem Vakuum und Plasmabehandlung mit dem Plasmagenerator des metallischen Substrats oder des nicht-metallischen Substrats, insbesondere Kunststoffsubstrats, oder der beschichtbaren Oberfläche des metallischen oder des nicht-metallischen Substrats, insbesondere Kunststoffsubstrats, im Vakuum,
e) gegebenenfalls Behandeln des nach Schritt a), c) oder d) erhaltenen metallischen Substrats oder nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit mindestens einer siliziumorganischen Verbindung, insbesondere mittels Plasmapolymerisation, insbesondere unter Ausbildung einer Polysiloxanschicht,
f) gegebenenfalls Plasmabehandlung mit dem Plasmagenerator der Schicht, insbesondere Polysiloxanschicht, gemäß Schritt e),
g) gegebenenfalls Aufbringen mindestens einer Grundierungsschicht auf das metallische Substrat oder das nicht-metallische Substrat, insbesondere Kunststoffsubstrat, oder die beschichtbare Oberfläche des metallischen Substrats oder des nicht-metallischen Substrats, insbesondere Kunststoffsubstrats, gemäß Schritt a), c) oder d) oder auf die Schicht, insbesondere Polysiloxanschicht, gemäß Schritt e) oder f),
h) gegebenenfalls Plasmabehandlung mit dem Plasmagenerator der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, insbesondere unter Ausbildung einer Polysiloxanschicht,
j) gegebenenfalls Plasmabehandlung mit dem Plasmagenerator der Schicht, insbesondere Polysiloxanschicht, gemäß Schritt i),
k) Aufbringen mindestens einer ersten Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das nicht-metallische Substrat, insbesondere Kunststoffsubstrat, oder auf die beschichtbare Oberfläche des nicht-metallischen Substrats, insbesondere Kunststoffsubstrats, gemäß Schritt a), c) oder d) oder auf die Schicht, insbesondere Polysiloxanschicht, gemäß Schritt e) oder f) oder auf die Grundierungsschicht gemäß Schritt g) oder h) oder auf die Schicht, insbesondere Polysiloxanschicht, gemäß Schritt i) oder j),
l) gegebenenfalls Plasmabehandlung mit dem Plasmagenerator der ersten Metallschicht gemäß Schritt k),
m) Behandeln der nach Schritt k) oder l) erhaltenen ersten Metallschicht mit mindestens einer siliziumorganischen Verbindung, insbesondere mittels Plasmapolymerisation, insbesondere unter Ausbildung einer Polysiloxanschicht,
n) Plasmabehandlung mit dem Plasmagenerator der Schicht, insbesondere Polysiloxanschicht, gemäß Schritt m)
o) Aufbringen mindestens einer, gegebenenfalls eingefärbten, Grundierungsschicht auf die Schicht, insbesondere Polysiloxanschicht, gemäß Schritt n),
p) Beaufschlagen der Grundierungsschicht gemäß Schritt o) mit einem Vakuum und Plasmabehandlung der Grundierungsschicht mit dem Plasmagenerator im Vakuum,
q) Aufbringen mindestens einer zweiten Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, insbesondere unmittelbar auf die plasmabehandelte Grundierungsschicht gemäß Schritt p),
r) gegebenenfalls Plasmabehandlung mit dem Plasmagenerator der zweiten Metallschicht gemäß Schritt q),
s) Behandeln der nach Schritt q) oder r) erhaltenen zweiten Metallschicht mit mindestens einer siliziumorganischen Verbindung, insbesondere mittels Plasmapolymerisation, insbesondere unter Ausbildung einer Polysiloxanschicht,
t) Plasmabehandlung mit dem Plasmagenerator der Schicht, insbesondere Polysiloxanschicht, gemäß Schritt s), und
u) Auftragen mindestens einer, insbesondere transparenten und/oder eingefärbten, Deckschicht auf die behandelte Schicht, insbesondere Polysiloxanschicht, gemäß Schritt t).

In einer praktikablen Ausgestaltung des erfindungsgemäßen Verfahrens umfasst dieses zusätzlich zu den Schritten a) und b) gegebenenfalls c) die Abfolge der Schritte d), insbesondere d1) und d2), k), o), p), q) und u), wobei diese, vorzugsweise unmittelbar, aufeinander folgen, insbesondere unter Auslassung der Schritte g), h), i) und j).

Ferner umfasst das erfindungsgemäße Verfahren solche besonders geeigneten Ausführungsformen, in denen die Schritte d), k), n), o), p), q) und u) oder die Schritte d), k), o), p), q), t) und u) oder die Schritte d), k), n), o), p), q), t) und u) oder die Schritte d), k), m), n), o), p), q), t) und u) oder die Schritte d), k), n), o), p), q), s), t) und u) oder die Schritte d), k), m), n), o), p), q), s), t) und u) jeweils, insbesondere unmittelbar, aufeinander folgen, insbesondere unter Auslassung der Schritte g), h), i) und j).

Gemäß bevorzugter Ausgestaltungen des erfindungsgemäßen Verfahrens kann auch vorgesehen sein, dass
die Schritte g), k), n), q), s), t) und u), insbesondere unter Auslassung der Schritte d) bis f), i), j), l), m), o), p) und r), oder
die Schritte g), h), insbesondere h1) und h2), k), n), q), s), t) und u), insbesondere unter Auslassung der Schritte d) bis f), i), j), l), m), o), p) und r), oder
die Schritte d), insbesondere d1) und d2), k), m), n), q), s), t) und u), insbesondere unter Auslassung der Schritte e) bis j), l), o), p) und r) oder unter Auslassung der Schritte e) bis j), l), und r),
die Schritte d), insbesondere d1) und d2), k), o), p), insbesondere p1) und p2), q) und u), insbesondere unter Auslassung der Schritte e) bis j), l), m), n) und r), oder unter Auslassung der Schritte e) bis j), l), m), n), r), s) und t), oder,
die Schritte d), insbesondere d1) und d2), k), n), o), p), insbesondere p1) und p2), q) und u), insbesondere unter Auslassung der Schritte e) bis j), l), m) und r) oder unter Auslassung der Schritte e) bis j), l), m), r), s) und t), oder
die Schritte d), insbesondere d1) und d2), k), o), p), insbesondere p1) und p2), q), t) und u), insbesondere unter Auslassung der Schritte e) bis j), l), m), n), r) und s), oder
die Schritte d), insbesondere d1) und d2), k), n), o), p), insbesondere p1) und p2), q), t) und u), insbesondere unter Auslassung der Schritte e) bis j), l), m), r) und s), oder
die Schritte d), insbesondere d1) und d2), k), m), n), o), p), insbesondere p1) und p2), q), t) und u), insbesondere unter Auslassung der Schritte e) bis j), l), r) und s), oder
die Schritte d), insbesondere d1) und d2), k), n), o), p), insbesondere p1) und p2), q), s), t) und u), insbesondere unter Auslassung der Schritte e) bis j), l), m) und r), oder
die Schritte d), insbesondere d1) und d2), k), m), n), o), p), insbesondere p1) und p2), q), s), t) und u), insbesondere unter Auslassung der Schritte e) bis j), l) und r),
jeweils, insbesondere unmittelbar, aufeinander folgen.

Für einige Anwendungen hat sich auch ein solches Verfahren als völlig ausreichend erwiesen, um die der Erfindung zugrunde liegenden Aufgaben zu lösen, das neben den Verfahrensschritten a), b) und c) auch die Verfahrensschritte d), k), o), p), q) und u) oder die Schritte d), k), n), o), p), q), t) und u) umfasst, wobei in einer bevorzugten Ausführungsform jeweils vor dem Schritt der Aufbringung der ersten und/oder zweiten Metallschicht k) bzw. q) auch die Aufbringung einer, insbesondere plasmagenerierten, Polysiloxanschicht vorgesehen werden kann.

Eine Behandlung bzw. ein Auftrag/eine Beschichtung auf "d1) und d2)" bzw. "insbesondere d1) und d2)" im Sinne der Erfindung soll bedeuten, dass der Auftrag/Behandlung/Beschichtung nach Schritt d2) folgt und dass der Schritt d1) dem Schritt d2) vorgeschaltet ist. Die Kombination der Merkmale d1) und d2) ist hierbei als Einheit zu betrachten. Demgemäß ist hiermit nicht gemeint, dass der Auftrag sowohl nach Schritt d1) als auch nach Schritt d2) stattzufinden hat. Entsprechendes gilt für die Merkmale "h1) und h2)" und "p1) und p2)".

In einer besonders zweckmäßigen Ausgestaltung, insbesondere wie vorangehend spezifiziert, wird die Schicht, auf die die erste Metallschicht gemäß Schritt k) und/oder die Schicht, auf die die zweite Metallschicht gemäß Schritt q) aufgebracht wird, vor dem Schritt k) bzw. vor dem Schritt q) einer Plasmabehandlung mit dem Plasmagenerator unterzogen.

Die der Erfindung zu Grunde liegende Aufgabe wird dabei insbesondere auch durch ein solches Verfahren gelöst, umfassend die Schritte
a) Zurverfügungstellung eines metallischen Substrats oder eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage, und Zurverfügungstellung mindestens eines Plasmagenerators, insbesondere in der Applikationsanlage für die Aufbringung einer Metallschicht, wie Vakuumaufdampfanlage oder Sputter-Anlage, oder als Bestandteil hiervon,
c) gegebenenfalls Reinigen der mindestens einen zumindest bereichsweise beschichtbaren Oberfläche,
d) Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit einem Vakuum und Plasmabehandlung mit dem Plasmagenerator des metallischen Substrats oder des nicht-metallischen Substrats, insbesondere Kunststoffsubstrats, oder der beschichtbaren Oberfläche des metallischen oder des nicht-metallischen Substrats, insbesondere Kunststoffsubstrats, im Vakuum,
e) gegebenenfalls Behandeln des nach Schritt a), c) oder d) erhaltenen metallischen Substrats oder nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit mindestens einer siliziumorganischen Verbindung, insbesondere mittels Plasmapolymerisation, insbesondere unter Ausbildung einer Polysiloxanschicht,
f) gegebenenfalls Plasmabehandlung mit dem Plasmagenerator der Schicht, insbesondere Polysiloxanschicht, gemäß Schritt e),
g) gegebenenfalls Aufbringen mindestens einer Grundierungsschicht auf das metallische Substrat oder das nicht-metallische Substrat, insbesondere Kunststoffsubstrat, oder die beschichtbare Oberfläche des metallischen Substrats oder des nicht-metallischen Substrats, insbesondere Kunststoffsubstrats, gemäß Schritt a), c) oder d) oder auf die Schicht, insbesondere Polysiloxanschicht, gemäß Schritt e) oder f),
h) gegebenenfalls Plasmabehandlung mit dem Plasmagenerator der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, insbesondere unter Ausbildung einer Polysiloxanschicht,
j) gegebenenfalls Plasmabehandlung mit dem Plasmagenerator der Schicht, insbesondere Polysiloxanschicht, gemäß Schritt i),
k) Aufbringen mindestens einer ersten Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das nicht-metallische Substrat, insbesondere Kunststoffsubstrat, oder auf die beschichtbare Oberfläche des nicht-metallischen Substrats, insbesondere Kunststoffsubstrats, gemäß Schritt a), c) oder d) oder auf die Schicht, insbesondere Polysiloxanschicht, gemäß Schritt e) oder f) oder auf die Grundierungsschicht gemäß Schritt g) oder h) oder auf die Schicht, insbesondere Polysiloxanschicht, gemäß Schritt i) oder j),
l) gegebenenfalls Plasmabehandlung mit dem Plasmagenerator der ersten Metallschicht gemäß Schritt k),
m) Behandeln der nach Schritt k) oder l) erhaltenen ersten Metallschicht mit mindestens einer siliziumorganischen Verbindung, insbesondere mittels Plasmapolymerisation, insbesondere unter Ausbildung einer Polysiloxanschicht,
n) Plasmabehandlung mit dem Plasmagenerator der Schicht, insbesondere Polysiloxanschicht, gemäß Schritt m)
o) Aufbringen mindestens einer, gegebenenfalls eingefärbten, Grundierungsschicht auf die Schicht, insbesondere Polysiloxanschicht, gemäß Schritt n),
p) Beaufschlagen der Grundierungsschicht gemäß Schritt o) mit einem Vakuum und Plasmabehandlung der Grundierungsschicht mit dem Plasmagenerator im Vakuum,
q) Aufbringen mindestens einer zweiten Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, insbesondere unmittelbar auf die plasmabehandelte Grundierungsschicht gemäß Schritt p),
r) gegebenenfalls Plasmabehandlung mit dem Plasmagenerator der zweiten Metallschicht gemäß Schritt q),
s) Behandeln der nach Schritt q) oder r) erhaltenen zweiten Metallschicht mit mindestens einer siliziumorganischen Verbindung, insbesondere mittels Plasmapolymerisation, insbesondere unter Ausbildung einer Polysiloxanschicht,
t) Plasmabehandlung mit dem Plasmagenerator der Schicht, insbesondere Polysiloxanschicht, gemäß Schritt s), und
u) Auftragen mindestens einer,insbesondere transparenten und/oder eingefärbten, Deckschicht auf die behandelte Schicht, insbesondere Polysiloxanschicht, gemäß Schritt t).

Bei dieser Verfahrensvariante sind die Schritte e) und f) sowie i) und j) nur optional. Sie können in Einzelfällen, insbesondere wenn die Schritte e) und f) und/oder die Schritte i) und j) zusammen vorgenommen werden, zu einer nochmals verbesserten Haftung und einem nochmals erhöhten Korrosionsschutz beitragen. Das gleiche trifft auf den optionalen Schritt i) zu.

Es hat sich für einige Anwendungen des erfindungsgemäßen Verfahrens gezeigt, dass es von Vorteil ist, wenn beidseitig der ersten Metallschicht und/oder beidseitig der zweiten Metallschicht, vorzugsweise beidseitig der ersten Metallschicht und beidseitig der zweiten Metallschicht, eine, insbesondere plasmagenerierte, Polysiloxanschicht vorliegt, die vorzugsweise jeweils einer Plasmabehandlung und/oder einer Corona-Behandlung, insbesondere Plasmabehandlung, unterzogen wurde.

Das erfindungsgemäße Verfahren umfasst in Schritt o), und gegebenenfalls in Schritt g), die Aufbringung einer Grundierungsschicht. Hierdurch lassen sich zum Beispiel Unebenheiten von zu beschichtenden Substraten mit minderer Qualität ausgleichen. Es hat sich überraschend gezeigt, dass durch Aufbringung der Grundierungsschicht auf die erste Metallschicht gemäß Schritt k), insbesondere wenn zuvor plasmabehandelt, vorzugsweise in Gegenwart von Argon, und mit einer Schicht gebildet aus siliziumorganischen Verbindungen, insbesondere einer Polysiloxanschicht, versehen (Schritte m) und n)), die Menge an Beschichtungsmaterial für die Grundierungsschicht signifikant reduziert werden kann, wobei gleichwohl stets ein deckende Auftrag gelingt. Ohne an eine Theorie gebunden zu sein, wird vermutet, dass Oberflächenspannungsphänomene hierfür verantwortlich sein könnten. Gleichzeitig erhält man einen sehr gleichmäßigen Verlauf des flüssigen Beschichtungsmaterials. Des Weiteren wurde überraschend gefunden, dass in dem erfindungsgemäßen Verfahren der Schritt der Aufbringung der Grundierungsschicht, insbesondere in Schritt o), mittels elektrostatischer Lackierung aufgetragen werden kann. Dies führt zu einer nochmaligen Verringerung der Menge an benötigtem Beschichtungsmaterial für die Grundierungsschicht. Auch kann so ein sehr gleichmäßiger Beschichtungsauftrag sichergestellt werden. Ferner gelingt auf diese Weise eine sogenannte Rundumlackierung wesentlich effektiver, d.h. es werden auch solche Areale beschichtet, die durch direkten Sprühauftrag nicht oder nur bedingt zugänglich sind. Das Verfahren der elektrostatischen Lackierung ist dem Fachmann bekannt. Mit dem erfindungsgemäßen Verfahren kann die aufgetragene Metallschicht, beispielsweise Aluminiumschicht, z.B. dazu genutzt werden, die erforderliche Spannung anzulegen. So kann in einer Ausführungsform beispielsweise eine positive Elektrode an das mit der Metallschicht beschichtete Substrat und eine negative Elektrode an eine Sprühvorrichtung angelegt werden. Auf diese Weise wird auch der Sprühstrahl entsprechend elektrisch aufgeladen.

Es hat sich als vorteilhaft erwiesen, die vorangehend genannten Verfahrensschritte im Wesentlichen unmittelbar aufeinanderfolgen zu lassen. Dies bedeutet insbesondere, dass nach den Plasmabehandlungsschritten eine längere Lagerung vermieden werden sollte. Vielmehr ist es von Vorteil, wenn der nachfolgende Verfahrensschritt direkt folgt. Auch hat sich gezeigt, dass neben den vorangehend genannten Verfahrensschritten es nicht zwingend erforderlich ist, weitere Verfahrensschritte zwischenzuschalten.

Geeignete nicht-metallische Substrate umfassen Glas, Keramik, Steinmaterialien, Verbundfasermaterialien, Carbonmaterialien, Kunststoff oder Holz. Besonders gut geeignet ist das hier geschilderte erfindungsgemäße Verfahren für die Beschichtung von Kunststoffsubstraten zwecks Erhalts dauerhaft hochglänzender Produkte. Geeignete Kunststoffsubstrate umfassen oder bestehen z.B. aus PVC, Polyurethanen, Polyacrylaten, Polyestern, z.B. PBT und PET, Polyolefinen, insbesondere Polypropylen, Polycarbonaten, Polyamiden, Polyphenylenethern, Polystyrol, Styrol(co)polymere, wie ABS, z.B. Galvano-ABS, SAN, ASA oder MABS, Polyoxyalkylene, z.B. POM, Teflon und Polymerblends, insbesondere ABS/PPE-, ASA/PPE-, SAN/PPE- und/oder ABS/PC-Blends.

Für die Metallsubstrate kann auf Metalle und Metalllegierungen zurückgegriffen werden, wobei besonders geeignete Metallsubstrate ausgewählt werden können aus der Gruppe bestehend aus Aluminium, Aluminiumlegierungen, Eisen, Eisenlegierungen, insbesondere Stahl oder Edelstahl, Kupfer, Kupferlegierungen, Titan, Titanlegierungen, Zink, Zinklegierungen, Nickel, Nicklegierungen, Molybdän, Molybdänlegierungen, Magnesium, Magnesiumlegierungen, Blei, Bleilegierungen, Wolfram, Wolframlegierungen, Mangan, Manganlegierungen, Messing, Bronze, Nickeldruckguss, Zinkdruckguss und Aluminiumdruckguss oder deren beliebige Mischungen.

Geeignete Verfahren zur Reinigung von Metallsubstraten sind dem Fachmann bekannt. Derartige Reinigungsverfahren umfassen das Entfetten, Dekapieren, Phosphatieren, insbesondere Eisen- und/oder Zinkphosphatieren, Polieren, Schleifen, insbesondere Gleitschleifen, und/oder Behandeln mit Trockeneis. Diese Verfahren können sowohl einzeln als auch in beliebiger Kombination eingesetzt werden. Für viele Anwendungen hatte sich als ausreichend erwiesen, die Metallsubstrate durch Behandlung mit Trockeneis zu reinigen und/oder diese zu entfetten. Vielfach reicht das Entfetten bereits aus. Ohne an eine Theorie gebunden zu sein, wird gegenwärtig vermutet, dass mit den nachfolgenden Verfahrensschritten des erfindungsgemäßen Verfahrens eine hinreichende Versiegelung bzw. Veredelung der Substratoberfläche erfolgt. Bei der Reinigung mit Trockeneis werden im Allgemeinen Trockeneispartikeln in Form von Pellets oder in Form von Kristallen, die von einem entsprechenden Trockeneisblock abgeschabt worden sind, mit Hilfe von Druckluft beschleunigt und auf die zu reinigende Metalloberfläche geleitet. Der Reinigungseffekt soll hierbei auf thermische, kinetische und Phasenumwandlungseffekte zurückzuführen sein. Vorrichtungen und Verfahren zur Reinigung von Metalloberflächen mit Trockeneis sind zum Beispiel der DE 195 44 906 A1 und EP 2 886 250 zu entnehmen.

Die Oberfläche von Metallsubstraten kann beispielsweise mit alkalischen oder sauren Reagenzien entfettet werden. Kommerzielle Entfettungsschritte sind auch unter den Begriffen Abkoch- bzw. Beizentfetten bekannt. Alternativ kann eine Metalloberfläche in einem elektrolytischen Entfettungsbad anodisch entfettet werden.

Für manche Ausführungsvarianten ist es vorteilhaft, die, insbesondere entfettete, Metallsubstratoberfläche mindestens einem Dekapierschritt zu unterziehen. Für die Dekapierung der Metallsubstratoberfläche setzt man z.B. ein saures Spülbad ein. Eine geeignete Dekapierlösung stellt demgemäß z.B. verdünnte Salzsäure (1:10 vol/vol) dar. Im Ergebnis erhält man mittels Dekapierung in der Regel eine im Wesentlichen oxidfreie Metalloberfläche. Ebenso wie der Entfettungsschritt wird auch der Dekapierschritt im Allgemeinen durch einen Spülschritt abgeschlossen. Wird die Metallsubstratoberfläche poliert und/oder geschliffen bzw. insbesondere gleitgeschliffen, kann häufig der Entfettungs- und/oder Dekapierschritt entfallen. Üblicherweise wird bei dieser Art der Oberflächenbearbeitung hinreichend Material von dieser Oberfläche abgetragen, womit dann auch auf der Oberfläche aufliegende bzw. anhaftende Verunreinigungen oder anderweitige Bestandteile mit entfernt werden. Wird die Oberfläche poliert bzw. geschliffen, insbesondere gleitgeschliffen, kann überdies häufig auch auf die Auftragung einer ersten und gegebenenfalls zweiten Grundierschicht verzichtet werden. Mit dem Polieren bzw. Schleifen wird zumeist bereits eine derart ebene bzw. glatte Oberfläche erhalten, dass eine Einglättung durch Aufbringen einer Grundierschicht nicht mehr erforderlich ist. Allerdings kann es, wenn das Metallsubstrat zahlreiche Winkel und Ecken aufweist, die sich nicht ohne weiteres hinreichend polieren bzw. schleifen lassen, empfehlenswert sein, einen ersten und möglicherweise auch einen zweiten Grundierschritt nachzuschalten.

Anschließend an oder anstelle des Entfettungsschritts kann die metallische Substratoberfläche phosphatiert und/oder zu passiviert werden. Dies ist insbesondere bei Substraten aus oder enthaltend Aluminium eine geeignete Vorgehensweise.

Zur Aufbringung einer Grundierungsschicht gemäß dem erfindungsgemäßen Verfahren stehen dem Fachmann allseits bekannte Verfahren zur Verfügung. Exemplarisch seien das Nasslackverfahren, das Pulverbeschichtungsverfahren oder die Auftragung mittels UVhärtender Beschichtungssysteme genannt. Demgemäß kann die Grundierungsschicht in einer bevorzugten Ausgestaltung auf, insbesondere UV-härtende, pulverförmige Polyesterharzverbindungen oder auf Epoxid/Polyester-Pulver zurückgehen. Dies Ergebnis ist insoweit überraschend, als UV-härtende Beschichtungen, beispielsweise Grundierungsbeschichtungen, regelmäßig zu sehr harten Schichten aushärten und für eine weitere Manipulation schwierig zugänglich sind und/oder zur Rissbildung neigen. Selbstverständlich ist es auch möglich, vor der Aufbringung einer Grundierungsschicht, wie vorangehend beschrieben, eine mechanische Glättung der Metallsubstratoberfläche, beispielsweise mittels Schleifens und/oder Polierens bzw. Gleitschleifens, durchzuführen.

Geeignete siliziumorganische Verbindungen sind dem Fachmann bekannt. In einer zweckmäßigen Ausgestaltung wird hierfür zurückgegriffen auf mindestens ein aminohaltiges Silan, insbesondere Aminopropyltriethoxysilan, Hexamethyldisiloxan, Tetramethyldisiloxan oder deren beliebige Mischungen. Besonders bevorzugt kommen Hexamethyldisiloxan und Tetramethyldisiloxan zum Einsatz, wobei Hexamethyldisiloxan regelmäßig besonders geeignet ist.

Geeignete siliziumorganische Verbindungen umfassen ebenfalls, als Monomer- oder als Comonomer-Bausteine, Verbindungen der folgenden Formel (I):

X-R₁-Si(R₂)₃₋ₘ(R₃)ₘ (I),

wobei die Substituenten und Indizes die folgende Bedeutung haben:
- m: 0, 1, 2 oder 3, insbesondere 2 oder 3,
- R1: C1- bis C10-Kohlenwasserstoffrest, insbesondere eine C1- bis C10-Kohlenwasserstoffkette, die durch Sauerstoff oder Stickstoff unterbrochen sein kann, insbesondere Methyl, Ethyl oder i- oder n-Propyl, vorzugsweise i- oder n-Propyl,
- R2: gleiche oder verschiedene hydrolysierbare Gruppen, insbesondere Alkoxygruppen wie Methoxy-, Ethoxy-, n-Propoxy, i-Propoxy, n-Butoxy, i-Butoxy oder t-Butoxy, insbesondere Methoxy oder Ethoxy,
- R3: gleiche oder verschiedene C1- bis C5-Alkylgruppen, insbesondere Methyl, Ethyl oder i- oder n-Propyl, vorzugsweise i- oder n-Propyl,
- X: funktionelle polymerisierbare Gruppe, insbesondere ein in ω-Stellung ungesättigter organischer Rest wie eine in ω-Stellung ungesättigte Alkenylgruppe mit 1 bis 10, vorzugsweise 2 bis 4 C-Atomen oder ein in ω-Stellung ungesättigter Carbonsäureesterrest von Carbonsäuren mit bis zu 4 Kohlenstoffatomen und Alkoholen mit bis zu 6 Kohlenstoffatomen.

Besonders geeignete Reste X umfassen z.B. Vinyl, Alkylvinyl, insbesondere Methyl-, Ethyl- oder Propylvinyl, (Meth)acryloxyalkyl, insbesondere (Meth)acryloxymethyl, (Meth)acryloxyethylen oder (Meth)acryloxypropyl, insbesondere (Meth)acryloxypropyl.

In einer zweckmäßigen Ausführungsform des erfindungsgemäßen Verfahrens ist vorgesehen, dass die siliziumorganische Verbindung über eine Zuführleitung aus einem außerhalb der Applikationsanlage für die Aufbringung einer Metallschicht, insbesondere außerhalb der Vakuumkammer der Vakuumaufdampfanlage, befindlichen Behältnis dieser Applikationsanlage, insbesondere Vakuumkammer, zugeführt wird. Auch ist es möglich, dass der siliziumorganischen Verbindung ein Farbmittel, insbesondere Farbstoff, zugesetzt ist. Demgemäß zeichnen sich die erfindungsgemäßen Verfahren in einer zweckmäßigen Ausgestaltung auch dadurch aus, dass man gemeinsam mit der mindestens einen siliziumorganischen Verbindung, insbesondere für die Plasmapolymerisation, mindestens ein Farbmittel, insbesondere einen Farbstoff, in die Applikationsanlage für die Aufbringung einer Metallschicht, vorzugsweise in Form eines Gemisches, einbringt.

Für die Durchführung des erfindungsgemäßen Verfahrens kann demgemäß auf eine Applikationsanlage für die Aufbringung einer Metallschicht zurückgegriffen werden, umfassend mindestens ein insbesondere außerhalb der Applikationsanlage für die Aufbringung einer Metallschicht, insbesondere außerhalb der Vakuumkammer der Vakuumaufdampfanlage, vorliegendes Behältnis zur Aufnahme einer siliziumorganischen Verbindung mit einer Zuführleitung zu der Applikationsanlage, insbesondere zur Vakuumkammer.

Eine gute Haftung ohne Einschränkungen bei der Korrosionsbeständigkeit kann man insbesondere auch dadurch erhalten, dass der Schritt der Behandlung mit mindestens einer siliziumorganischen Verbindung wie Hexamethyldisiloxan, insbesondere mittels Plasmapolymerisation, unter Ausbildung einer Polysiloxanschicht in Gegenwart mindestens eines reaktiven Gases wie Sauerstoff, Stickstoff, Kohlendioxid, Wasserstoff, Kohlenmonoxid, Wasserstoffperoxidgas, Wasserdampf, Ozon und/oder Luft, insbesondere in Gegenwart von Sauerstoff oder Luft, durchgeführt wird. Über die Einbindung von reaktiven Gasen, insbesondere Luft oder Sauerstoff, in den, insbesondere plasmagenerierten, Polymerisationsprozess erhält man härtere Polysiloxanschichten als bei der herkömmlichen Herstellung solcher Polysiloxanschichten ohne Mitverwendung der geschilderten reaktiven Gas. Diese härteren Polysiloxanschichten zeichnen sich auch durch eine größere Diffusionsgeschlossenheit aus. Hierbei kann in einer besonders zweckmäßigen Ausführungsform vorgesehen sein, dass die mindestens eine siliziumorganische Verbindung, insbesondere Hexamethyldisiloxan, und das mindestens eine reaktive Gas, insbesondere Sauerstoff oder Luft, als Mischung für den Behandlungsschritt eingesetzt werden. Die vorangehend geschilderte Ausführungsform der Mitverwendung reaktive Gase bei der, insbesondere plasmagenerierten, Herstellung der Polysiloxanschicht kommt vorzugsweise bei mindestens einem Schritt der Behandlung mit mindestens einer siliziumorganischen Verbindung, insbesondere mittels Plasmapolymerisation, unter Ausbildung einer Polysiloxanschicht oder aber auch bei jedem Schritt zur Herstellung einer Polysiloxanschicht zum Einsatz. Besonders bevorzugt wird diese Verfahrensvariante bei der Herstellung beschichteter metallischer Substrate und bei der Herstellung beschichteter nicht-metallischer Substrate, insbesondere von Kunststoffsubstraten, in Verfahrensschritt m) und/oder s) eingesetzt. In dem dem genannten Verfahrensschritt m) folgenden Verfahrensschritt n) wird die Plasmabehandlung bevorzugt mit Hilfe eines Plasmagases gebildet aus einem Inertgas, insbesondere Argon, und in dem dem genannten Verfahrensschritt s) folgenden Verfahrensschritt t) wird die Plasmabehandlung bevorzugt mit Hilfe eines Plasmagases gebildet aus Sauerstoff oder Luft oder Stickstoff, insbesondere Sauerstoff, durchgeführt. Auch diese Vorgehensweise trägt nochmals zu einer verbesserten Haftung des Gesamtsystems bei.

Für den Schritt der Plasmabehandlung mit dem Plasmagenerator stehen grundsätzlich mehrere Verfahrensvarianten zur Auswahl. Gemäß einer ersten Variante kann das Plasma unter Einsatz mindestens eines Inertgases, insbesondere Argon, gebildet werden. Alternativ kann für die Generierung eines geeigneten Plasmas auch auf Mischungen aus mindestens einem Inertgas, insbesondere Argon, und einem reaktiven Gas wie Sauerstoff, Stickstoff, Kohlendioxid, Wasserstoff, Kohlenmonoxid, Wasserstoffperoxidgas, Wasserdampf, Ozon und/oder Luft zurückgegriffen werden. Bevorzugt kommen hierbei Sauerstoff und Stickstoff, insbesondere Sauerstoff, zum Einsatz. Schließlich ist es auch möglich, unter Verzicht von Inertgasen ausschließlich reaktive Gase wie Sauerstoff, Stickstoff, Wasserstoff, Kohlendioxid, Kohlenmonoxid, Wasserstoffperoxidgas, Wasserdampf, Ozon und/oder Luft für die Erzeugung des Plasmas einzusetzen. Hierbei wird bevorzugt auf Sauerstoff zurückgegriffen. Mit Hilfe einer Plasmabehandlung mit dem Plasmagenerator wird die zu beschichtende Oberfläche des Substrats aktiviert. Bei einem Plasmaverfahren wirkt regelmäßig ein energiereiches Plasma auf die Oberfläche des Formteils ein, so dass auf dieser Oberfläche aktive Zentren gebildet werden. Hierbei kann es sich beispielsweise um Hydroxygruppen und/oder um Carbonyl-Gruppen handeln.

Demgemäß kann in einer besonders geeigneten Ausgestaltung des erfindungsgemäßen Verfahrens vorgesehen sein, dass der Schritt der Plasmabehandlung mit dem Plasmagenerator unter Einsatz von mindestens einem Inertgas, insbesondere Argon, oder unter Einsatz von mindestens einem Inertgas, insbesondere Argon, und Sauerstoff, Stickstoff, Kohlendioxid, Wasserstoff, Kohlenmonoxid, Wasserstoffperoxidgas, Wasserdampf, Ozon und/oder Luft, insbesondere Sauerstoff, oder unter Einsatz von Sauerstoff, Stickstoff, Wasserstoff, Kohlendioxid, Kohlenmonoxid, Wasserstoffperoxidgas, Wasserdampf, Ozon und/oder Luft, insbesondere Sauerstoff, vorzugsweise unter Ausschluss von Inertgasen, durchgeführt wird.

Dabei sind solche Verfahrensvarianten besonders bevorzugt, bei denen die, insbesondere jede, Plasmabehandlung mit dem Plasmagenerator und/oder die, insbesondere jede, Aufbringung der ersten und zweiten Metallschicht und/oder die, insbesondere jede, Aufbringung der durch Plasmabehandlung von siliziumorganischen Verbindungen erhaltenen Schicht, insbesondere Polysiloxanschicht, in der Applikationsanlage für die Aufbringung einer Metallschicht, insbesondere in der Vakuumaufdampfanlage oder in der Sputter-Anlage, vorgenommen wird. Insbesondere werden dabei die vorangehend genannten Verfahrensschritte e), l), m), n) und s) im Vakuum vorgenommen.

Die der Erfindung zu Grunde liegende Aufgabe wird besonders gut gelöst durch solche erfindungsgemäßen Verfahren, bei denen die Plasmabehandlung gemäß Schritt d) und/oder p), vorzugsweise gemäß Schritt d) und p), unter Einsatz von Argon, in einer zweckmäßigen Ausgestaltung unter Ausschluss von Luft oder Sauerstoff, und/oder, vorzugsweise und, bei denen die Plasmabehandlung gemäß Schritt n) und/oder t), vorzugsweise gemäß Schritt n) und t), unter Einsatz von Sauerstoff, in einer zweckmäßigen Ausgestaltung unter Ausschluss von Inertgasen wie Argon, durchgeführt wird.

Das erfindungsgemäße Verfahren bietet den großen Vorteil, dass nahezu sämtliche Verfahrensschritte in der Applikationsanlage für die Aufbringung einer Metallschicht durchgeführt werden können. Dies betrifft neben der Aufbringung der ersten und zweiten Metallschicht auch die Aktivierung von Oberflächen mittels der Plasmabehandlung mit dem Plasmagenerator ebenso wie die Aufbringung der Schicht gebildet aus siliziumorganischen Verbindungen, insbesondere der Polysiloxanschicht, insbesondere mittels Plasmapolymerisation. Einzig die Reinigungsschritte, die Aufbringung der Grundierungsschicht und die Aufbringung der Deckschicht werden regelmäßig außerhalb der genannten Applikationsanlage aufgebracht. Demgemäß kann vorgesehen sein, dass die, insbesondere jede, Plasmabehandlung mit dem Plasmagenerator und/oder die, insbesondere jede, Aufbringung der ersten und zweiten Metallschicht und/oder die, insbesondere jede, Aufbringung der Schicht gebildet aus siliziumorganischen Verbindungen, insbesondere der Polysiloxanschicht, in der Applikationsanlage für die Aufbringung einer Metallschicht, insbesondere in der Vakuumaufdampfanlage oder in der Sputter-Anlage, vorgenommen wird. Dabei werden vorzugsweise die, insbesondere jede, Plasmabehandlung mit dem Plasmagenerator und die, insbesondere jede, Aufbringung der ersten und zweiten Metallschicht und die, insbesondere jede, Aufbringung der Schicht gebildet aus siliziumorganischen Verbindungen, insbesondere der Polysiloxanschicht, in der Applikationsanlage für die Aufbringung einer Metallschicht, insbesondere in der Vakuumaufdampfanlage oder in der Sputter-Anlage, vorgenommen. Bevorzugt werden in einer Ausgestaltung des erfindungsgemäßen Verfahrens dabei die Aufbringung der Grundierungsschicht und/oder, vorzugsweise und, die Aufbringung der Deckschicht außerhalb der Applikationsanlage für die Aufbringung einer Metallschicht, insbesondere der Vakuumaufdampfanlage oder der Sputter-Anlage, durchgeführt.

Für die Deckschicht kann z.B. auch auf wasserverdünnbare Beschichtungszusammensetzungen zurückgegriffen werden. Die Deckschicht kann gebildet werden aus Polyacrylatharzen, Polyesterharzen, Aminoplastharzen oder Polyurethanverbindungen. Bevorzugt werden bei den erfindungsgemäßen Verfahren solche Deckschichten aufgetragen, die auf ein UVhärtendes Beschichtungsmaterial zurückgehen. Demgemäß stellt eine bevorzugte Deckschicht eine UV-gehärtete Deckschicht dar. Die Deckschicht kann z.B. über einen Klarlack oder ein transparentes Pulver erhalten werden. Vorzugsweise wird die Deckschicht über ein Nasslackverfahren bzw. ein Pulverbeschichtungsverfahren aufgetragen. Bei der Deckschicht kann es sich demgemäß zum Beispiel um ein-, zwei- oder mehrkomponentige Lacke handeln, wobei Klarlacke bevorzugt sind. Bei diesen Klarlacken kann es sich z.B. um chemisch vernetzende zweikomponentige, um einkomponentige wärmehärtende oder um UV-härtende Lacke handeln. Des Weiteren kann für die Deckschicht auf 1K- oder 2K-Einbrennlack zurückgegriffen werden. Grundsätzlich können die für die Grundierungsschicht und die Deckschicht verwendeten Materialien in einer Ausführungsform auch übereinstimmen.

Des Weiteren wurde überraschend gefunden, dass in dem erfindungsgemäßen Verfahren auch der Schritt der Aufbringung der Deckschicht mittels elektrostatischer Lackierung aufgetragen werden kann. Dies führt zu einer nochmaligen Verringerung der Menge an benötigtem Beschichtungsmaterial für die Deckschicht. Auch kann so ein sehr gleichmäßiger Beschichtungsauftrag sichergestellt werden. Ferner gelingt auf diese Weise eine sogenannte Rundumlackierung wesentlich effektiver, d.h. es werden auch solche Areale beschichtet, die durch direkten Sprühauftrag nicht oder nur bedingt zugänglich sind.

Die Deckschicht verfügt in der Regel über eine Dicke im Bereich von 10 bis 50 µm, vorzugsweise im Bereich von 20 bis 30 µm. Erfindungswesentlich für die erfindungsgemäßen Verfahren ist, dass das die Deckschicht bildende Material auf eine zuvor mittels Plasmabehandlung und/oder Corona-Behandlung aktivierte Polysiloxanschicht, welche wiederum bevorzugt im Wege einer Plasmapolymerisation erhalten wurde, aufgetragen wird, und zwar vorzugsweise im Wesentlichen ohne zeitliche Verzögerung.

Die Plasmabehandlung mit dem Plasmagenerator wird mitunter auch mit dem Begriff Glimmen beschrieben.

Für die Auftragung der Metallschichten kann zum Beispiel zurückgegriffen werden auf die Techniken der Physical Vapour Deposition (PVD), Chemical Vapour Deposition (CVD), des Aufdampfens mittels eines Elektronenstahl-Verdampfers, des Aufdampfens mittels eines Widerstandsverdampfers, der Induktionsverdampfung, der ARC-Verdampfung oder der Kathoden- bzw. Anodenzerstäubung (Sputter-Beschichtung). Demgemäß kommen als Applikationsanlagen für die Aufbringung einer Metallschicht zum Beispiel vorzugsweise Vakuumaufdampfanlagen oder Sputter-Anlagen in Frage. Geeignete Vakuumaufdampfanlagen umfassen zweckmäßigerweise PVD-Anlagen (Physical Vapour Deposition), CVD-Anlagen (Chemical Vapour Deposition), Elektronenstahl-Verdampfer, Widerstandsverdampfer, Induktionsverdampfer und ARC-Verdampfer. Geeignete Sputter-Anlagen umfassen zum Beispiel Kathodenzerstäuber und Anodenzerstäuber. Wie dem Fachmann bekannt ist, besteht eine Metallschicht vorwiegend aus Metall. Dies schließt Zusätze, wie sie beispielsweise bei rostfreiem Stahl in Form von Kohlenstoff zum Einsatz kommen, nicht gänzlich aus. Vorzugsweise ist der Metallanteil der vorliegenden Metallschicht größer 90 Gew%, insbesondere 95 Gew% und ganz besonders bevorzugt ≥ 98 Gew%. Selbstverständlich können die erste und die zweite Metallschicht auch mit voneinander verschiedenen Verfahren aufgetragen werden. Bevorzugt wird für die Auftragung der ersten Metallschicht und der zweiten Metallschicht auf ein und dasselbe Verfahren zurückgegriffen.

Vorzugsweise ist die Metallschicht eine aufgedampfte oder aufgesputterte Metallschicht, insbesondere ein PVD-Metallschicht. Beim PVD-Verfahren kommen im Allgemeinen widerstandsbeheizte Metallwendel- oder Metallschiffchenverdampfer zum Einsatz, wobei Wolframwendeln der verschiedensten Form bevorzugt sind. Beim PVD-Verfahren wird im Allgemeinen ein Verdampfer mit Wendeln bestückt, die auf voneinander isolierten Verdampferschienen geklemmt werden können. In jede Wendel wird vorzugsweise eine genau bestimmte Menge an aufzudampfendem Metall gegeben. Nach dem Schließen und Evakuieren der PVD-Anlage kann die Verdampfung durch Einschalten der Stromversorgung, wodurch man die Verdampferschienen die Wendel zum Glühen bringt, gestartet werden. Das feste Metall beginnt zu schmelzen und benetzt die meist verdrillten Wendeln vollständig. Durch weitere Energiezufuhr wird das flüssige Metall in die Gasphase überführt, so dass es sich auf dem zu beschichtenden Substrat abscheiden kann. Über die Menge an in die Gasphase überführtem Metall und/oder die Dauer der Beschichtungsphase kann die Dicke der Metallschicht, und damit auch das Erscheinungsbild derselben gezielt eingestellt werden.

Ein weiteres bevorzugtes Verfahren zur Abscheidung der Metallschicht auf dem Substrat ist die Kathodenzerstäubung (Sputter-Verfahren). Dabei wird in einem evakuierten Behälter eine Kathode angeordnet, die mit dem negativen Pol einer Stromversorgung verbunden ist. Das Beschichtungsmaterial, das zerstäubt wird, wird unmittelbar vor der Kathode montiert und die zu beschichtenden Substrate werden gegenüber dem zu zerstäubenden Beschichtungsmaterial angeordnet. Ferner kann Argon als Prozessgas durch den Behälter geleitet werden, der schließlich noch eine Anode aufweist, die mit dem positiven Pol einer Stromversorgung verbunden ist. Nachdem der Behälter vorevakuiert worden ist, "werden Kathode und Anode mit der Stromversorgung verbunden. Durch den gezielten und gesteuerten Einlass von Argon wird die mittlere freie Weglänge der Ladungsträger deutlich gesenkt. Im elektrischen Feld zwischen Kathode und Anode werden Argonatome ionisiert. Die positiv geladenen Teilchen werden mit hoher Energie zur negativ geladenen Kathode beschleunigt. Beim Auftreffen und durch Teilchenstöße im Beschichtungsmaterial wird dieses in die Dampfphase überführt, mit hoher Energie in den freien Raum beschleunigt und kondensiert dann auf den zu beschichtenden Substraten. Mit dem Sputter-Verfahren lassen sich unterschiedliche Metallschichtdicken gezielt einstellen.

Die mit den genannten Verfahren und Anlagen erhältlichen Metallschichten verfügen vorzugsweise über eine durchschnittliche, insbesondere absolute, Dicke im Bereich von 1 nm bis 150 nm insbesondere im Bereich von 5 nm bis 120 nm. In einer sehr zweckmäßigen Ausgestaltung des erfindungsgemäßen beschichteten Substrats wird die Metallschicht zum Beispiel mit einer Dicke im Bereich von 60 nm bis 120 nm, vorzugsweise mit einer Dicke im Bereich von 75 nm bis 110 nm eingestellt. Bei diesen Dicken liegen die Metallschicht, insbesondere die Aluminiumschicht, deckend, d.h. im Wesentlichen nicht transparent oder transluzent auf der Oberfläche auf. Hierdurch können hochglänzende Schichten erhalten werden.

Gemäß einer ebenfalls besonders zweckmäßigen Ausgestaltung des erfindungsgemäßen Verfahrens wird die mit der mit der Applikationsanlage aufgebrachte zweite Metallschicht, insbesondere Aluminiumschicht, in Schritt q) in einer Dicke aufgetragen, insbesondere aufgedampft oder aufgesputtert, dass diese Metallschicht, insbesondere auch nach Schritt r), s), t) und/oder u) oder nach Schritt s), t) und/oder u), für sichtbares Licht transparent oder transluzent ist. Alternativ und insbesondere zusätzlich kann dabei vorgesehen sein, dass die mit der mit der Applikationsanlage aufgebrachte erste Metallschicht, insbesondere Aluminiumschicht, in Schritt k) in einer Dicke aufgetragen, insbesondere aufgedampft oder aufgesputtert, wird, dass diese Metallschicht für sichtbares Licht nicht transparent und nicht transluzent ist.

Eine Einfärbung der auf den nicht-metallischen und metallischen Substraten vorliegenden Beschichtung kann mit den erfindungsgemäßen Verfahren auch dadurch bewerkstelligt werden, dass für das Auftragen der Deckschicht ein Beschichtungsmaterial enthaltend mindestens ein Farbmittel, z.B. mindestens ein Pigment und/oder mindestens einen Farbstoff, eingesetzt wird. Auch lassen sich dem Fachmann bekannte Lasuren verwenden, um die Deckschicht einzufärben, beispielsweise um Messing-, Titan- und Goldtöne oder individuelle Farbtöne wie rot, blau, gelb, grün, etc. oder Eloxalfarbtöne zu erhalten. Zum Beispiel können in die Deckschicht auch Effektpigmente wie Perlglanzpigmente, LCP-Pigmente (liquid crystal polymer) oder OV-Pigmente (optical variable) eingearbeitet werden.

Die der Erfindung zu Grunde liegende Aufgabe wird des Weiteren gelöst durch ein beschichtetes metallisches oder nicht-metallisches Substrat, insbesondere erhalten oder erhältlich nach dem erfindungsgemäßen Verfahren, umfassend
A) ein, insbesondere gereinigtes, vorzugsweise entfettetes, metallisches oder nicht-metallisches Substrat,
K) mindestens eine, insbesondere eine, mit einer Applikationsanlage, insbesondere mittels Aufdampf- und/oder Sputter-Technik, aufgebrachte erste Metallschicht,
O) mindestens eine, insbesondere eine, Grundierungsschicht,
Q) mindestens eine, insbesondere eine, mit einer Applikationsanlage, insbesondere mittels Aufdampf- und/oder Sputter-Technik, aufgebrachte zweite Metallschicht, und
U) mindestens eine, insbesondere eine, insbesondere transparente und/oder eingefärbte, Deckschicht; oder
A) ein, insbesondere gereinigtes, vorzugsweise entfettetes, metallisches oder nicht-metallisches Substrat,
K) mindestens eine, insbesondere eine, mit einer Applikationsanlage, insbesondere mittels Aufdampf- und/oder Sputter-Technik, aufgebrachte erste Metallschicht,
M) mindestens eine, insbesondere eine, aus mindestens einer siliziumorganischen Verbindung, insbesondere mittels Plasmapolymerisation, gebildete Schicht, insbesondere Polysiloxanschicht,
O) mindestens eine, insbesondere eine, Grundierungsschicht,
Q) mindestens eine, insbesondere eine, mit einer Applikationsanlage, insbesondere mittels Aufdampf- und/oder Sputter-Technik, aufgebrachte zweite Metallschicht,
S) mindestens eine, insbesondere eine, aus mindestens einer siliziumorganischen Verbindung, insbesondere mittels Plasmapolymerisation, gebildete Schicht, insbesondere Polysiloxanschicht, und
U) mindestens eine, insbesondere eine, insbesondere transparente und/oder eingefärbte, Deckschicht; oder
A) ein, insbesondere gereinigtes, vorzugsweise entfettetes, metallisches oder nicht-metallisches Substrat,
G) mindestens eine, insbesondere eine, Grundierungsschicht,
K) mindestens eine, insbesondere eine, mit einer Applikationsanlage, insbesondere mittels Aufdampf- und/oder Sputter-Technik, aufgebrachte, mit einem Plasma, insbesondere Argon- und/oder Sauerstoffplasma, im Vakuum behandelte und/oder coronabehandelte, insbesondere plasmabehandelte, erste Metallschicht,
Q) mindestens eine, insbesondere eine, mit einer Applikationsanlage, insbesondere mittels Aufdampf- und/oder Sputter-Technik, aufgebrachte zweite Metallschicht,
S) mindestens eine, insbesondere eine, aus mindestens einer siliziumorganischen Verbindung, insbesondere mittels Plasmapolymerisation, gebildete Schicht, insbesondere Polysiloxanschicht, und
U) mindestens eine, insbesondere eine, insbesondere transparente und/oder eingefärbte, Deckschicht; oder
A) ein, insbesondere gereinigtes, vorzugsweise entfettetes, metallisches oder nicht-metallisches Substrat,
G) gegebenenfalls mindestens eine, insbesondere eine, Grundierungsschicht,
K) mindestens eine, insbesondere eine, mit einer Applikationsanlage, insbesondere mittels Aufdampf- und/oder Sputter-Technik, aufgebrachte, insbesondere mit einem Plasma, insbesondere Argon- und/oder Sauerstoffplasma, im Vakuum behandelte und/oder coronabehandelte, insbesondere plasmabehandelte, erste Metallschicht,
M) mindestens eine, insbesondere eine, aus mindestens einer siliziumorganischen Verbindung, insbesondere mittels Plasmapolymerisation, gebildete Schicht, insbesondere Polysiloxanschicht,
O) mindestens eine, insbesondere eine, Grundierungsschicht,
Q) mindestens eine, insbesondere eine, mit einer Applikationsanlage, insbesondere mittels Aufdampf- und/oder Sputter-Technik, aufgebrachte zweite Metallschicht,
S) mindestens eine, insbesondere eine, aus mindestens einer siliziumorganischen Verbindung, insbesondere mittels Plasmapolymerisation, gebildete Schicht, insbesondere Polysiloxanschicht, und
U) mindestens eine, insbesondere eine, insbesondere transparente und/oder eingefärbte, Deckschicht.

Solche erfindungsgemäßen beschichteten metallischen Substrate und solche erfindungsgemäßen beschichtete nicht-metallische Substrate lösen die der Erfindung zu Grunde liegende Aufgabe besonders gut, bei denen das zu beschichtende metallische oder nicht-metallische Substrat gemäß A) ein mit einem Plasma, insbesondere Argonplasma, im Vakuum behandeltes Substrat darstellt und/oder bei denen
die aus mindestens einer siliziumorganischen Verbindung gebildete Schicht, insbesondere Polysiloxanschicht, gemäß C) eine mit einem Plasma, insbesondere Sauerstoffplasma, im Vakuum behandelte Schicht darstellt und/oder bei denen
die Grundierungsschicht gemäß G) eine mit einem Plasma, insbesondere Argonplasma, im Vakuum behandelte Grundierungsschicht darstellt und/oder bei denen
die Grundierungsschicht gemäß O) eine mit einem Plasma, insbesondere Argonplasma, im Vakuum behandelte Grundierungsschicht darstellt und/oder bei denen
die erste Metallschicht K) eine mit einem Plasma, insbesondere Sauerstoff- und/oder Argonplasma, im Vakuum behandelte Metallschicht darstellt und/oder bei denen
die zweite Metallschicht Q) eine mit einem Plasma, insbesondere Sauerstoff- und/oder Argonplasma, im Vakuum behandelte Metallschicht darstellt und/oder bei denen
die aus mindestens einer siliziumorganischen Verbindung gebildete Schicht, insbesondere Polysiloxanschicht, gemäß M) eine mit einem Plasma, insbesondere Argon- und/oder Sauerstoffplasma, im Vakuum behandelte Schicht darstellt und/oder bei denen
die aus mindestens einer siliziumorganischen Verbindung gebildete Schicht, insbesondere Polysiloxanschicht, gemäß S) eine mit einem Plasma, insbesondere Argon- und/oder Sauerstoffplasma, im Vakuum behandelte Schicht darstellt.

Hierbei sind solche erfindungsgemäßen beschichteten metallischen und nicht-metallischen Substrate besonders geeignet, bei denen das zu beschichtende metallische oder nicht-metallische Substrat gemäß A) ein mit einem Plasma, insbesondere Argonplasma, im Vakuum behandeltes Substrat darstellt und bei denen die aus mindestens einer siliziumorganischen Verbindung gebildete Schicht, insbesondere Polysiloxanschicht, gemäß C) eine mit einem Plasma, insbesondere Sauerstoffplasma, im Vakuum behandelte Schicht darstellt und bei denen die Grundierungsschicht gemäß D) eine mit einem Plasma, insbesondere Argonplasma, im Vakuum behandelte Grundierungsschicht darstellt und bei denen die aus mindestens einer siliziumorganischen Verbindung gebildete Schicht, insbesondere Polysiloxanschicht, gemäß F) eine mit einem Plasma, insbesondere Sauerstoffplasma, im Vakuum behandelte Schicht darstellt.

Für die Durchführung des erfindungsgemäßen Verfahrens kann auch auf eine Applikationsanlage für die Aufbringung einer Metallschicht zurückgegriffen werden, umfassend oder darstellend eine Vakuumaufdampfanlage mit einer Vakuumkammer, und mindestens eine, insbesondere eine Vielzahl an ersten beheizbaren Aufnahmeeinheiten, insbesondere Schalen, Schiffchen oder Wendeln, jeweils in Wirkverbindung mit einer Heizeinrichtung oder eine Heizeinrichtung umfassend oder darstellend, jeweils ausgelegt und geeignet für die Aufnahme eines Metalls oder einer Metalllegierung, und ferner eine Steuereinrichtung für die Einstellung der Schmelz- bzw. Verdampfungstemperatur.

Dabei kann in einer Ausführungsvariante vorgesehen sein, dass die Applikationsanlage für die Aufbringung einer Metallschicht mindestens ein, insbesondere außerhalb der Vakuumkammer der Vakuumaufdampfanlage vorliegendes Behältnis zur Aufnahme einer siliziumorganischen Verbindung mit einer Zuführleitung zur Vakuumkammer umfasst.

Als besonders zweckdienlich hat es sich erwiesen, die Applikationsanlage für die Aufbringung der ersten und/oder zweiten Metallschicht ebenfalls auszustatten mit mindestens einem, insbesondere in der Vakuumkammer vorliegenden, Gestell mit einer Längsorientierung und mit mindestens einem Träger, insbesondere in Form einer Welle, der im Wesentlichen entlang der Längsorientierung des Gestells ausgerichtet ist, ausgelegt und eingerichtet zur Aufnahme mindestens eines, insbesondere einer Vielzahl an nicht-metallischen und/oder metallischen Substraten, wobei das Gestell und/oder der mindestens eine Träger um eine, insbesondere im Wesentlichen horizontal ausgerichtete, Achse rotiert wahr sind. Geeignete Gestelle, die mit der Applikationsanlage verwendet werden können, sind zum Beispiel der EP 2 412 445 und der DE 20 2007 016 072 zu entnehmen.

Die nach dem erfindungsgemäßen Verfahren erhältlichen beschichteten nicht-metallischen und metallischen Substrate können zum Beispiel eingesetzt werden als Zubehörteil für den Automobilbau, Motorradbau, Fahrradbau oder Schiffbau, für Felgen, insbesondere Leichtmetallfelgen, Räder, insbesondere Leichtmetallräder oder als Bestandteil hiervon, für Sanitäreinrichtungsgegenstände, insbesondere als Armatur, oder als Bestandteil hiervon, für Karosserieinnen- oder Außenbauteile oder als Bestandteil hiervon, für Griffe oder Griffkomponenten, insbesondere Türgriffe oder als Bestandteil hiervon, für Profile oder Rahmen, insbesondere Fensterrahmen oder als Bestandteil hiervon, für Beschlagsysteme oder als Bestandteil hiervon, insbesondere Schilder und Türschilder, für Gehäuse oder als Verpackung oder als Bestandteil hiervon, für Innen- oder Außenbauteile von Schiffen oder als Bestandteil hiervon, für Schmuckgegenstände oder als Bestandteil hiervon, für Edelbauteile oder als Bestandteil hiervon, für Innen- oder Außenmöbel oder für Bestandteile hiervon, für Haushaltsgeräte, insbesondere Kaffeemaschinen, oder Bestandteile hiervon, für Innen- oder Außenbauteile von Flugzeugen oder als Bestandteil hiervon, für Innen- oder Außenbauteile von Gebäuden oder als Bestandteil hiervon, für Heizkörper oder Rohre oder als Bestandteil hiervon, für Bauteile von Aufzügen oder als Bestandteil hiervon, für Bauteile von Elektronikkomponenten oder -Geräten oder als Bestandteil hiervon, für Bauteile von Küchengeräten, beispielsweise Kaffeemaschinen, oder als Bauteil von Kommunikationskomponenten oder -Geräten, insbesondere Handys, oder als Bestandteil hiervon.

Die erfindungsgemäßen beschichteten Substrate bzw. die nach den erfindungsgemäßen Verfahren erhältlichen beschichteten Substrate bestehen regelmäßig den Dampfstrahltest, z.B. nach DIN EN ISO 16925:2014-06, den Kondenswasser-Konstantklima-Test, z.B. nach DIN EN ISO 6270-2, den Hydrolysetest, z.B. nach BMW-Norm AA-0203 oder AA-P 308, den Salzsprühnebeltest, z.B. nach DIN EN ISO 9227 und/oder die Gitterschnittprüfung, z.B. nach DIN EN ISO 2409:2013-06. Bevorzugt können sogar sämtliche bzw. nahezu sämtliche der genannten Tests bestanden werden.

Der Erfindung liegt die überraschende Erkenntnis zugrunde, dass mit den erfindungsgemäßen Substraten, insbesondere mit den nach den erfindungsgemäßen Verfahren erhältlichen Substraten eine hochwertige Glanzbeschichtung zur Verfügung gestellt wird, die dauerhaft ihren Glanz behält. Außerdem wurde überraschend gefunden, dass die erfindungsgemäßen Substrate, insbesondere die nach dem erfindungsgemäßen Verfahren erhältlichen beschichteten nicht-metallischen und metallischen Substrate mit einer hervorragenden Korrosionsbeständigkeit ausgestattet sind. Die nach den erfindungsgemäßen Verfahren erhältlichen beschichteten Substrate zeichnen sich zudem durch eine ausgeprägte Haftung aus. Demgemäß zeigen diese beschichteten Substrate selbst dann überragende Korrosionsbeständigkeiten, wenn die Oberflächen mechanische Beschädigungen erfahren haben, beispielsweise mittels Steinschlag oder durch Anritzen. Ein weiterer Vorteil, der mit den erfindungsgemäßen Verfahren sowie mit der erfindungsgemäßen Applikationsanlage einhergeht, ist, dass nur noch sehr geringe Umrüstzeiten erforderlich sind, um neue Substratschargen zu beschichten. Darüber hinaus ermöglicht das erfindungsgemäße Verfahren, den Umfang der Gesamtanlage zur Herstellung beschichteter Substrate ausgehend von dem noch nicht gereinigten, zu beschichtenden Substrat erheblich zu verringern, so dass ein signifikant reduzierter Platzbedarf gegenüber herkömmlichen Anlagen besteht. Darüber hinaus gelingt es mit den erfindungsgemäßen Verfahren, die Bearbeitungszeit bis zur Fertigstellung des beschichteten verkaufsfertigen Substrats erheblich zu verringern. Hiermit gehen zwangsläufig verringerte Zykluszeiten einher.

Von ganz besonderem, überraschendem Vorteil ist auch, dass die erfindungsgemäßen beschichteten Substrate, insbesondere die mit dem erfindungsgemäßen Verfahren hergestellten beschichteten Substrate weder Kantenaufbau noch Kantenflucht bzw. nahezu keinen Kantenaufbau und nahezu keine Kantenflucht zeigen, und gleichzeitig auch in der Massenfertigung einen signifikant verringerten Anteil an Ausschussware mit sich bringen. Es gelingt auf zuverlässige und reproduzierbare Weise, selbst hochwertige Chromoberflächen identisch nachzustellen, ohne dass hierbei Chrom oder andere Schwermetalle zum Einsatz kommen. Mit dem erfindungsgemäßen Verfahren können der Einsatz an Beschichtungsmaterial für die Grundierungsschicht und auch an Beschichtungsmaterial für die Deckschicht signifikant reduziert werden, beispielsweise um mindestens 50 und vielfach sogar um mindestens 70 Gewichtsprozent. Nichtsdestotrotz erhält man verlässlich einen deckenden Auftrag, wobei der Verlauf des Beschichtungsmaterials sehr hohen Anforderungen genügt. Schließlich stellen sich obige Vorteile überraschenderweise selbst bei Verringerung der Vorbehandlungs- bzw. Reinigungsschritte und/oder bei Verringerung des Vorbehandlungs- bzw. Reinigungsaufwands ein.

Die in der vorstehenden Beschreibung und in den Ansprüchen offenbarten Merkmale der Erfindung können sowohl einzeln aus auch in jeder beliebigen Kombination für die Verwirklichung der Erfindung in ihren verschiedenen Ausführungsformen wesentlich sein.

## Patentansprüche

1. Verfahren zur Herstellung eines beschichteten metallischen Substrats oder eines beschichteten nicht-metallischen Substrats, insbesondere Kunststoffsubstrats, umfassend
a) Zurverfügungstellung eines metallischen Substrats oder eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage, und Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
c) gegebenenfalls Reinigen der mindestens einen zumindest bereichsweise beschichtbaren Oberfläche,
d) gegebenenfalls Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, mit einem Vakuum (d1)) und/oder Plasmabehandlung mit dem Plasmagenerator und/oder Corona-Behandlung, insbesondere Plasmabehandlung, des metallischen Substrats oder des nicht-metallischen Substrats, insbesondere Kunststoffsubstrats, oder der beschichtbaren Oberfläche des nicht-metallischen Substrats, insbesondere Kunststoffsubstrats, oder des metallischen Substrats, vorzugsweise im Vakuum (d2)),
e) gegebenenfalls Behandeln des nach Schritt a), c) oder d), insbesondere nach d1) und d2), erhaltenen metallischen Substrats oder nicht-metallischen Substrats, insbesondere Kunststoffsubstrats, oder der nach Schritt a), c) oder d), insbesondere nach d1) und d2), erhaltenen beschichtbaren Oberfläche des metallischen Substrats oder des nicht-metallischen Substrats, insbesondere Kunststoffsubstrats, mit mindestens einer siliziumorganischen Verbindung, insbesondere mittels Plasmapolymerisation, insbesondere unter Ausbildung einer Polysiloxanschicht,
f) gegebenenfalls Plasmabehandlung mit dem Plasmagenerator und/oder Corona-Behandlung, insbesondere Plasmabehandlung, der Schicht, insbesondere Polysiloxanschicht, gemäß Schritt e),
g) gegebenenfalls Aufbringen mindestens einer Grundierungsschicht auf das metallische Substrat oder das nicht-metallische Substrat, insbesondere Kunststoffsubstrat, oder die beschichtbare Oberfläche des metallischen Substrats oder des nicht-metallischen Substrats, insbesondere Kunststoffsubstrats, gemäß Schritt a), c) oder d), insbesondere gemäß d1) und d2), oder auf die Schicht, insbesondere Polysiloxanschicht, gemäß Schritt e) oder f),
h) gegebenenfalls Beaufschlagen des metallischen Substrats oder des nicht-metallischen Substrats, insbesondere Kunststoffsubstrats, oder der beschichtbaren Oberfläche des metallischen Substrats oder des nicht-metallischen Substrats, insbesondere Kunststoffsubstrats, gemäß Schritt g) mit einem Vakuum (h1)) und/oder Plasmabehandlung mit dem Plasmagenerator und/oder Corona-Behandlung, insbesondere Plasmabehandlung, des metallischen Substrats oder des nicht-metallischen Substrats, insbesondere Kunststoffsubstrats, oder der beschichtbaren Oberfläche des nicht-metallischen Substrats, insbesondere Kunststoffsubstrats, oder des metallischen Substrats gemäß Schritt h1) oder Schritt g), vorzugsweise im Vakuum (h2)),
i) gegebenenfalls Behandeln der nach Schritt g) oder h), insbesondere nach h1) und h2), erhaltenen Grundierungsschicht mit mindestens einer siliziumorganischen Verbindung, insbesondere mittels Plasmapolymerisation, insbesondere unter Ausbildung einer Polysiloxanschicht,
j) gegebenenfalls Plasmabehandlung mit dem Plasmagenerator und/oder Corona-Behandlung, insbesondere Plasmabehandlung, der Schicht, insbesondere Polysiloxanschicht, gemäß Schritt i),
k) Aufbringen mindestens einer ersten Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das nicht-metallische Substrat, insbesondere Kunststoffsubstrat, oder auf die beschichtbare Oberfläche des nicht-metallischen Substrats, insbesondere Kunststoffsubstrats, gemäß Schritt a), c) oder d), insbesondere gemäß d1) und d2), oder auf die Schicht, insbesondere Polysiloxanschicht, gemäß Schritt e) oder f) oder auf die Grundierungsschicht gemäß Schritt g) oder h), insbesondere gemäß h1) und h2), oder auf die Schicht, insbesondere Polysiloxanschicht, gemäß Schritt i) oder j),
l) gegebenenfalls Plasmabehandlung mit dem Plasmagenerator und/oder Corona-Behandlung, insbesondere Plasmabehandlung, der ersten Metallschicht gemäß Schritt k),
m) vorzugsweise Behandeln der nach Schritt k) oder l) erhaltenen ersten Metallschicht mit mindestens einer siliziumorganischen Verbindung, insbesondere mittels Plasmapolymerisation, insbesondere unter Ausbildung einer Polysiloxanschicht,
n) vorzugsweise Plasmabehandlung mit dem Plasmagenerator und/oder Corona-Behandlung, insbesondere Plasmabehandlung, der Schicht, insbesondere Polysiloxanschicht, gemäß Schritt m),
o) Aufbringen mindestens einer, gegebenenfalls eingefärbten, Grundierungsschicht auf die Schicht, insbesondere Polysiloxanschicht, gemäß Schritt n),
p) Beaufschlagen der Grundierungsschicht gemäß Schritt o) mit einem Vakuum (p1)) und/oder Plasmabehandlung der Grundierungsschicht, vorzugsweise im Vakuum, mit dem Plasmagenerator im Vakuum und/oder Corona-Behandlung, insbesondere Plasmabehandlung (p2)),
q) Aufbringen mindestens einer zweiten Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, insbesondere unmittelbar auf die plasma- und/oder coronabehandelte, insbesondere plasmabehandelte, Grundierungsschicht gemäß Schritt p), insbesondere gemäß p1) und p2),
r) gegebenenfalls Plasmabehandlung, vorzugsweise im Vakuum, mit dem Plasmagenerator und/oder Corona-Behandlung, insbesondere Plasmabehandlung, der zweiten Metallschicht gemäß Schritt q),
s) vorzugsweise Behandeln der nach Schritt q) oder r) erhaltenen zweiten Metallschicht mit mindestens einer siliziumorganischen Verbindung, insbesondere mittels Plasmapolymerisation, insbesondere unter Ausbildung einer Polysiloxanschicht,
t) vorzugsweise Plasmabehandlung, vorzugsweise im Vakuum, mit dem Plasmagenerator und/oder Corona-Behandlung, insbesondere Plasmabehandlung, der Schicht, insbesondere Polysiloxanschicht, gemäß Schritt s), und
u) Auftragen mindestens einer, insbesondere transparenten und/oder eingefärbten, Deckschicht auf die behandelte Schicht, insbesondere Polysiloxanschicht, gemäß Schritt t).

2. Verfahren nach Anspruch 1, **dadurch gekennzeichnet, dass**
die Schritte g), k), n), q), s), t) und u), insbesondere unter Auslassung der Schritte d) bis f), i), j), l), m), o), p) und r), oder
die Schritte g), h), insbesondere h1) und h2), k), n), q), s), t) und u), insbesondere unter Auslassung der Schritte d) bis f), i), j), l), m), o), p) und r), oder
die Schritte d), insbesondere d1) und d2), k), m), n), q), s), t) und u), insbesondere unter Auslassung der Schritte e) bis j), l), o), p) und r) oder unter Auslassung der Schritte e) bis j), l), und r), oder
die Schritte d), insbesondere d1) und d2), k), o), p), insbesondere p1) und p2), q) und u), insbesondere unter Auslassung der Schritte e) bis j), l), m), n) und r), oder unter Auslassung der Schritte e) bis j), l), m), n), r), s) und t), oder,
die Schritte d), insbesondere d1) und d2), k), n), o), p), insbesondere p1) und p2), q) und u), insbesondere unter Auslassung der Schritte e) bis j), l), m) und r) oder unter Auslassung der Schritte e) bis j), l), m), r), s) und t), oder
die Schritte d), insbesondere d1) und d2), k), o), p), insbesondere p1) und p2), q), t) und u), insbesondere unter Auslassung der Schritte e) bis j), l), m), n), r) und s), oder
die Schritte d), insbesondere d1) und d2), k), n), o), p), insbesondere p1) und p2), q), t) und u), insbesondere unter Auslassung der Schritte e) bis j), l), m), r) und s), oder die Schritte d), insbesondere d1) und d2), k), m), n), o), p), insbesondere p1) und p2), q), t) und u), insbesondere unter Auslassung der Schritte e) bis j), l), r) und s), oder
die Schritte d), insbesondere d1) und d2), k), n), o), p), insbesondere p1) und p2), q), s), t) und u), insbesondere unter Auslassung der Schritte e) bis j), l), m) und r), oder die Schritte d), insbesondere d1) und d2), k), m), n), o), p), insbesondere p1) und p2), q), s), t) und u), insbesondere unter Auslassung der Schritte e) bis j), l) und r), jeweils, insbesondere unmittelbar, aufeinander folgen.

3. Verfahren nach Anspruch 1 oder 2, **dadurch gekennzeichnet, dass**
das nicht-metallische Substrat Glas, Steinmaterialien, Keramik, Verbundfasermaterialien, Carbonmaterialien, Kunststoff oder Holz umfasst oder hieraus besteht oder dass das Metallsubstrat Metalle oder Metalllegierungen umfasst oder hieraus besteht, insbesondere ausgewählt ist aus der Gruppe bestehend aus Aluminium, Aluminiumlegierungen, Eisen, Eisenlegierungen, insbesondere Stahl oder Edelstahl, Kupfer, Kupferlegierungen, Titan, Titanlegierungen, Zink, Zinklegierungen, Nickel, Nicklegierungen, Molybdän, Molybdänlegierungen, Magnesium, Magnesiumlegierungen, Blei, Bleilegierungen, Wolfram, Wolframlegierungen, Mangan, Manganlegierungen, Messing, Bronze, Nickeldruckguss, Zinkdruckguss und Aluminiumdruckguss oder deren beliebigen Mischungen.

4. Verfahren nach einem oder mehreren der vorangehenden Ansprüche, **dadurch gekennzeichnet, dass**
die siliziumorganische Verbindung mindestens ein aminohaltiges Silan, insbesondere Amino-propyltriethoxysilan, Hexamethyldisiloxan, Tetramethyldisiloxan oder deren beliebige Mischungen umfasst, insbesondere Hexamethyldisiloxan.

5. Verfahren nach einem oder mehreren der vorangehenden Ansprüche, **dadurch gekennzeichnet, dass**
die, insbesondere jede, Plasmabehandlung mit dem Plasmagenerator und/oder die, insbesondere jede, Aufbringung der ersten und zweiten Metallschicht und/oder die, insbesondere jede, Aufbringung der durch Plasmabehandlung von siliziumorganischen Verbindungen erhaltenen Schicht, insbesondere Polysiloxanschicht, in der Applikationsanlage für die Aufbringung einer Metallschicht, insbesondere in der Vakuumaufdampfanlage oder in der Sputter-Anlage, vorgenommen wird.

6. Verfahren nach einem oder mehreren der vorangehenden Ansprüche, **dadurch gekennzeichnet, dass**
die Deckschicht Polyacrylatharze, Polyesterharze, Aminoplastharze oder Polyurethanverbindungen umfasst oder hieraus besteht und/oder dass die Deckschicht aus einem UV-härtenden Beschichtungsmaterial oder aus einem 1K- oder 2K-Einbrennlack gebildet ist, insbesondere eine UV-gehärtete Deckschicht oder eine 1K- oder 2K-Einbrennlack-Deckschicht darstellt.

7. Verfahren nach einem oder mehreren der vorangehenden Ansprüche, **dadurch gekennzeichnet, dass**
die erste und die zweite Metallschicht, unabhänig voneinander, mittels Physical Vapour Deposition (PVD), Chemical Vapour Deposition (CVD), Aufdampfen mittels eines Elektronenstahl-Verdampfers, Aufdampfen mittels eines Widerstandsverdampfers, Induktionsverdampfung, ARC-Verdampfung oder Kathoden- bzw. Anodenzerstäubung (Sputter-Beschichtung) aufgebracht werden, wobei insbesondere in dem Schritt k) und/oder dem Schritt q) der Aufbringung der ersten bzw. zweiten Metallschicht ein erstes bzw. zweites Metall, insbesondere Aluminium, oder eine erste bzw. zweite Metalllegierung, insbesondere Aluminiumlegierung, in der Applikationsanlage für die Aufbringung einer Metallschicht, insbesondere der Vakuumaufdampfanlage oder der Sputter-Anlage, verdampft wird.

8. Verfahren nach einem oder mehreren der vorangehenden Ansprüche, **dadurch gekennzeichnet, dass**
die Plasmabehandlung mit dem Plasmagenerator und/oder das Behandeln des mit mindestens einer siliziumorganischen Verbindung, insbesondere mittels Plasmapolymerisation, insbesondere unter Ausbildung einer Polysiloxanschicht, und/oder das Aufbringen der mindestens einen ersten Metallschicht und der mindestens einen zweiten Metallschicht mit der Applikationsanlage unter Vakuum vorgenommen werden.

9. Verfahren nach einem oder mehreren der vorangehenden Ansprüche, **dadurch gekennzeichnet, dass**
die Plasmabehandlung gemäß Schritt d), insbesondere gemäß d1) und d2), und/oder p), insbesondere gemäß p1) und p2), unter Einsatz von Argon und/oder dass die Plasmabehandlung gemäß Schritt n) und/oder t) unter Einsatz von Sauerstoff durchgeführt wird.

10. Verfahren nach einem oder mehreren der vorangehenden Ansprüche, **dadurch gekennzeichnet, dass**
die mit der mit der Applikationsanlage aufgebrachte zweite Metallschicht, insbesondere Aluminiumschicht, in Schritt q) in einer Dicke aufgetragen, insbesondere aufgedampft oder aufgesputtert, wird, dass diese Metallschicht, insbesondere auch nach Schritt r), s), t) und/oder u) oder nach Schritt s), t) und/oder u), für sichtbares Licht transparent oder transluzent ist, und/oder
dass die mit der mit der Applikationsanlage aufgebrachte erste Metallschicht, insbesondere Aluminiumschicht, in Schritt k) in einer Dicke aufgetragen, insbesondere aufgedampft oder aufgesputtert, wird, dass diese Metallschicht für sichtbares Licht nicht transparent und nicht transluzent ist.

11. Verfahren nach einem oder mehreren der vorangehenden Ansprüche, **dadurch gekennzeichnet, dass**
die Grundierungsschicht und/oder die Deckschicht nach dem Nasslackverfahren oder dem Pulverbeschichtungsverfahren erhalten wird.

12. Verfahren nach einem oder mehreren der vorangehenden Ansprüche, **dadurch gekennzeichnet, dass**
die Grundierungsschicht, insbesondere in Schritt o), und/oder die Deckschicht mittels elektrostatischer Lackierung aufgetragen wird.

13. Beschichtetes metallisches oder nicht-metallisches Substrat, insbesondere erhalten oder erhältlich nach einem Verfahren gemäß einem oder mehreren der vorangehenden Ansprüche, umfassend
A) ein, insbesondere gereinigtes, vorzugsweise entfettetes, metallisches oder nicht-metallisches Substrat,
K) mindestens eine, insbesondere eine, mit einer Applikationsanlage, insbesondere mittels Aufdampf- und/oder Sputter-Technik, aufgebrachte erste Metallschicht,
O) mindestens eine, insbesondere eine, Grundierungsschicht,
Q) mindestens eine, insbesondere eine, mit einer Applikationsanlage, insbesondere mittels Aufdampf- und/oder Sputter-Technik, aufgebrachte zweite Metallschicht, und
U) mindestens eine, insbesondere eine, insbesondere transparente und/oder eingefärbte, Deckschicht; oder
A) ein, insbesondere gereinigtes, vorzugsweise entfettetes, metallisches oder nicht-metallisches Substrat,
K) mindestens eine, insbesondere eine, mit einer Applikationsanlage, insbesondere mittels Aufdampf- und/oder Sputter-Technik, aufgebrachte erste Metallschicht,
M) mindestens eine, insbesondere eine, aus mindestens einer siliziumorganischen Verbindung, insbesondere mittels Plasmapolymerisation, gebildete Schicht, insbesondere Polysiloxanschicht,
O) mindestens eine, insbesondere eine, Grundierungsschicht,
Q) mindestens eine, insbesondere eine, mit einer Applikationsanlage, insbesondere mittels Aufdampf- und/oder Sputter-Technik, aufgebrachte zweite Metallschicht,
S) mindestens eine, insbesondere eine, aus mindestens einer siliziumorganischen Verbindung, insbesondere mittels Plasmapolymerisation, gebildete Schicht, insbesondere Polysiloxanschicht, und
U) mindestens eine, insbesondere eine, insbesondere transparente und/oder eingefärbte, Deckschicht; oder
A) ein, insbesondere gereinigtes, vorzugsweise entfettetes, metallisches oder nicht-metallisches Substrat,
G) mindestens eine, insbesondere eine, Grundierungsschicht,
K) mindestens eine, insbesondere eine, mit einer Applikationsanlage, insbesondere mittels Aufdampf- und/oder Sputter-Technik, aufgebrachte, mit einem Plasma, insbesondere Argon- und/oder Sauerstoffplasma, im Vakuum behandelte und/oder coronabehandelte, insbesondere plasmabehandelte, erste Metallschicht,
Q) mindestens eine, insbesondere eine, mit einer Applikationsanlage, insbesondere mittels Aufdampf- und/oder Sputter-Technik, aufgebrachte zweite Metallschicht,
S) mindestens eine, insbesondere eine, aus mindestens einer siliziumorganischen Verbindung, insbesondere mittels Plasmapolymerisation, gebildete Schicht, insbesondere Polysiloxanschicht, und
U) mindestens eine, insbesondere eine, insbesondere transparente und/oder eingefärbte, Deckschicht; oder
A) ein, insbesondere gereinigtes, vorzugsweise entfettetes, metallisches oder nicht-metallisches Substrat,
G) gegebenenfalls mindestens eine, insbesondere eine, Grundierungsschicht,
K) mindestens eine, insbesondere eine, mit einer Applikationsanlage, insbesondere mittels Aufdampf- und/oder Sputter-Technik, aufgebrachte, insbesondere mit einem Plasma, insbesondere Argon- und/oder Sauerstoffplasma, im Vakuum behandelte und/oder coronabehandelte, insbesondere plasmabehandelte, erste Metallschicht,
M) mindestens eine, insbesondere eine, aus mindestens einer siliziumorganischen Verbindung, insbesondere mittels Plasmapolymerisation, gebildete Schicht, insbesondere Polysiloxanschicht,
O) mindestens eine, insbesondere eine, Grundierungsschicht,
Q) mindestens eine, insbesondere eine, mit einer Applikationsanlage, insbesondere mittels Aufdampf- und/oder Sputter-Technik, aufgebrachte zweite Metallschicht,
S) mindestens eine, insbesondere eine, aus mindestens einer siliziumorganischen Verbindung, insbesondere mittels Plasmapolymerisation, gebildete Schicht, insbesondere Polysiloxanschicht, und
U) mindestens eine, insbesondere eine, insbesondere transparente und/oder eingefärbte, Deckschicht.

14. Beschichtetes metallisches oder nicht-metallisches Substrat nach Anspruch 13, **dadurch gekennzeichnet, dass**
das zu beschichtende metallische oder nicht-metallische Substrat gemäß A) ein mit einem Plasma, insbesondere Argonplasma, im Vakuum behandeltes Substrat darstellt und/oder dass
die aus mindestens einer siliziumorganischen Verbindung gebildete Schicht, insbesondere Polysiloxanschicht, gemäß C) eine mit einem Plasma, insbesondere Sauerstoffplasma, im Vakuum behandelte Schicht darstellt und/oder dass die Grundierungsschicht gemäß G) eine mit einem Plasma, insbesondere Argonplasma, im Vakuum behandelte Grundierungsschicht darstellt und/oder dass die Grundierungsschicht gemäß O) eine mit einem Plasma, insbesondere Argonplasma, im Vakuum behandelte Grundierungsschicht darstellt und/oder dass die erste Metallschicht K) eine mit einem Plasma, insbesondere Sauerstoff- und/oder Argonplasma, im Vakuum behandelte Metallschicht darstellt und/oder dass
die zweite Metallschicht Q) eine mit einem Plasma, insbesondere Sauerstoff- und/oder Argonplasma, im Vakuum behandelte Metallschicht darstellt und/oder dass
die aus mindestens einer siliziumorganischen Verbindung gebildete Schicht, insbesondere Polysiloxanschicht, gemäß M) eine mit einem Plasma, insbesondere Argon- und/oder Sauerstoffplasma, im Vakuum behandelte Schicht darstellt und/oder dass
die aus mindestens einer siliziumorganischen Verbindung gebildete Schicht, insbesondere Polysiloxanschicht, gemäß S) eine mit einem Plasma, insbesondere Argon- und/oder Sauerstoffplasma, im Vakuum behandelte Schicht darstellt.

15. Verwendung des beschichteten metallischen oder nicht-metallisches Substrats, erhalten oder erhältlich nach einem Verfahren gemäß einem der Ansprüche 1 bis 12, oder gemäß Anspruch 13 oder 14 als Zubehörteil für den Automobilbau, Motorradbau, Fahrradbau oder Schiffbau, für Felgen, insbesondere Leichtmetallfelgen, Räder, insbesondere Leichtmetallräder oder als Bestandteil hiervon, für Sanitäreinrichtungsgegenstände, insbesondere als Armatur, oder als Bestandteil hiervon, für Karosserieinnen- oder Außenbauteile oder als Bestandteil hiervon, für Griffe oder Griffkomponenten, insbesondere Türgriffe oder als Bestandteil hiervon, für Profile oder Rahmen, insbesondere Fensterrahmen oder als Bestandteil hiervon, für Beschlagsysteme oder als Bestandteil hiervon, insbesondere Schilder und Türschilder, für Gehäuse oder als Verpackung oder als Bestandteil hiervon, für Innen- oder Außenbauteile von Schiffen oder als Bestandteil hiervon, für Haushaltsgeräte, insbesondere Kaffeemaschinen, oder Bestandteile hiervon, für Schmuckgegenstände oder als Bestandteil hiervon, für Edelbauteile oder als Bestandteil hiervon, für Innen- oder Außenmöbel oder für Bestandteile hiervon, für Innen- oder Außenbauteile von Flugzeugen oder als Bestandteil hiervon, für Innen- oder Außenbauteile von Gebäuden oder als Bestandteil hiervon, für Heizkörper oder Rohre oder als Bestandteil hiervon, für Bauteile von Aufzügen oder als Bestandteil hiervon, für Bauteile von Elektronikkomponenten oder -Geräten oder als Bestandteil hiervon, für Bauteile von Küchengeräten, beispielsweise Kaffeemaschinen, oder als Bauteil von Kommunikationskomponenten oder -Geräten, insbesondere Handys, oder als Bestandteil hiervon.
